# FASCICULE DE BREVET EUROPEEN

(11) **EP 4 481 634 B1**
(45) Date de publication et mention de la délivrance du brevet: **03.06.2026**
(21) Numéro de dépôt: 24183217.9
(22) Date de dépôt: 19.06.2024
(51) Int. Cl.: G06N 10/40

(54) **DISPOSITIF POUR LECTURE ET DÉCODAGE D'UNE INFORMATION QUANTIQUE**
VORRICHTUNG ZUM LESEN UND DECODIEREN VON QUANTUMINFORMATIONEN
DEVICE FOR READING AND DECODING QUANTUM INFORMATION

(30) Priorité: 22.06.2023 FR 2306530
(43) Date de publication de la demande: 25.12.2024
(73) Titulaire: Commissariat à l'Energie Atomique et aux Energies Alternatives, 75015 Paris (FR)
(72) Inventeur: SCHMIDT, Quentin, 38054 GRENOBLE Cedex 09 (FR); BADETS, Franck, 38054 GRENOBLE Cedex 09 (FR); THONNART, Yvain, 38054 GRENOBLE Cedex 09 (FR); JADOT, Baptiste, 38054 GRENOBLE Cedex 09 (FR)
(74) Mandataire: Atout PI Laplace

(56) Documents cités:
- US-A1- 2022 188 687

## Description

### Domaine de l'invention

1. L'invention concerne la lecture et le décodage d'une information quantique, dans le cadre de la mise en oeuvre de circuits électroniques ou informatiques fondés sur des bits quantiques, ou qubits.

### Etat de la technique

2. L'informatique quantique est un domaine technique en développement, basé sur l'utilisation d'un état quantique à deux niveaux mesurables comme vecteur d'information, appelé bit quantique ou « quantum bit » en anglais ou encore couramment qubit.

3. Différentes technologies de mises en oeuvre existent, parmi lesquelles les qubits supraconducteurs, basés notamment sur l'utilisation de jonctions Josephson, tels les qubits de charge notamment les transmons.

4. Par ailleurs, on connait la technologie des qubits de spin. Ceux-ci sont constitués d'un électron ou d'un trou d'électron (couramment appelé trou), de spin ½ et dont les deux orientations possibles du spin définissent les niveaux mesurables de l'information. Les qubits de spin peuvent être formés dans du matériau semi-conducteur, comme du silicium, à fort potentiel d'intégration. Des électrons ou des trous sont individuellement confinés dans des puits quantiques maintenus à des températures cryogéniques dans un cryostat et réalisés au sein de structures de confinement de tailles nanométriques définies de manière électrostatique, appelées « quantum dots » ou boîte quantique.

5. La lecture des qubits de spin, fait face, à l'instar de la lecture des qubits d'autres technologies, à de nombreux défis. Principalement du fait de la température de fonctionnement des qubits, en général inférieure à 1 K, l'environnement proche des qubits est peu favorable à des circuits électroniques de lecture. Qui plus est, il est nécessaire de lire des qubits en grand nombre, ce qui implique des contraintes de consommation électrique et de taille. Il est également nécessaire de lutter contre le bruit électromagnétique et de minimiser les temps de lecture face au temps de cohérence des qubits.

6. Différentes solutions ont été proposées. Il a été proposé des circuits électroniques de lecture au plus proche des qubits et donc à basse température, ou au contraire dans un environnement plus éloigné et donc moins froid.

7. Il a été aussi proposé d'utiliser des techniques de lecture soit par réflectométrie (le qubit est atteint à l'aide d'un câble unique - l'excitation et la lecture se faisant à l'aide de ce cable unique) soit par lecture par électrométrie, à savoir à l'aide d'un électromètre c'est-à-dire un composant électronique permettant une lecture par mesure de charge. On s'intéresse ici à des électromètres qualifiés de quantiques, parce qu'ils interagissent avec le qubit par l'intermédiaire de boîtes quantiques. Un tel électromètre présente une sensibilité à la charge réglée par (au moins) un pôle appelé grille, et deux pôles de lecture appelés source et drain permettant la création d'un courant (ou d'une tension) par variation de conductance en fonction de la charge dans la boîte quantique.

8. Avec les méthodes de lecture par réflectométrie, basées sur l'envoi d'une onde de jusqu'à quelques GHz vers les qubits (qubits supraconducteurs ou qubits de spin), et sur l'observation de l'onde réfléchie, il est en général nécessaire de faire sortir du cryostat un nombre de connexions filaires (câbles) égal au nombre de qubits à lire, ce qui devient très difficile si le nombre de qubits est important.

9. Alternativement, il est proposé d'envoyer plusieurs signaux à différentes fréquences par la même connexion filaire (câble), selon le principe du multiplexage fréquentiel, et de parvenir à traiter différemment ces fréquences dans le cryostat grâce à des résonateurs LC adaptés et placés au sein de celui-ci, et couplés à chaque qubit. Dans cette dernière solution, il est nécessaire que la fréquence de résonance du résonateur LC associée à chaque qubit soit finement différente pour chaque résonateur, ce qui est exigeant en matériel et en temps de lecture, et constitue donc un frein technologique actuellement. Pour générer ces signaux proches en fréquence, il est connu de synthétiser un peigne à basse fréquence avec un générateur analogique, puis de le multiplier par une plus haute fréquence porteuse. Le signal réfléchi est alors démodulé par cette porteuse, puis numérisé pour extraire le signal associé à chaque qubit. Le nombre de qubits pouvant ainsi être examinés est inévitablement limité par la bande passante du générateur analogique et du convertisseur analogique vers numérique.

10. Des méthodes de lecture par réflectométrie sont connues de Park, 2021, Jerger 2012, Abdo 2018, Naaman, 2021 et Bronn, 2022.

11. La méthode par lecture par charge (et donc par électrométrie), pour les qubits de spin, consiste quant à elle dans un premier temps à favoriser une conversion spin vers charge puis dans un deuxième temps à mesurer un courant de sortie généré par couplage électrostatique capacitif avec la boîte quantique du qubit de spin d'un électromètre quantique (c'est-à-dire un appareil mesurant la charge électrique, et comprenant un contact quantique ou une boite quantique, qui, pour la mesure est couplé à la boîte quantique d'un objet à mesurer, en l'occurrence ici un qubit). Le spin du qubit est ainsi converti en une information de courant. On utilise un transistor à un électron (« Single Electron Transistor » en anglais, ou SET) ou un contact ponctuel quantique (« Quantum Point Contact » en anglais, ou QPC) qui sont des exemples non limitatifs d'électromètre quantique. La détection de courant (quelques nanoampères à la sortie d'un SET) est effectuée à l'aide d'un amplificateur courant-tension, de type amplificateur à transimpédance (TIA). Ces amplificateurs peuvent être placés à température ambiante (300K), ou à température proche de 4K ou inférieure à 1K, avec des compromis en consommation électrique et bande-passante.

12. Des méthodes de lecture par électrométrie sont connues de Williams, 2009, Gong, 2019 et Morel, 2022. On envisage d'autres techniques de lecture par électrométrie, qui au lieu d'être fondées sur une mesure de courant, sont fondées sur une mesure de tension.

13. Le multiplexage fréquentiel peut être utilisé afin d'augmenter le nombre de qubits atteignables pour l'opération de lecture. Cette stratégie utilise une répartition des qubits dans la bande passante du système de lecture en assignant à chacun d'eux une fréquence différente.

14. Cela peut se faire par l'utilisation de résonateurs matériels couplés aux qubits définissant des fréquences différentes dans le cas de l'utilisation de la réflectométrie. On connait ainsi de Jerger, 2012 un système avec des résonateurs matériels couplés aux qubits définissant des fréquences différentes, ce qui constitue une proposition pour diminuer le nombre de câbles dans le cryostat au vu du nombre de qubits, dans un système de lecture par réflectométrie. La méthode de démodulation est adaptée pour doubler le nombre de qubits lus par rapport à des techniques antérieures au vu de la bande passante disponible, en utilisant une voie d'intégration en phase et une voie d'intégration en quadrature (IQ), et en adressant individuellement la bande haute et basse du spectre. Mais ce principe reste limité à un facteur 2 d'amélioration, et impose en plus de dédoubler le nombre de chaines de démodulation ou de doubler le temps de lecture, alors qu'on souhaiterait obtenir une plus grande simplification pour lire de très nombreux qubits.

15. Le multiplexage fréquentiel peut se faire aussi en excitant les couples constitués par les électromètres et les qubits associés par des circuits distincts, ce qui est avantageux, car cela permet de changer les fréquences sans changer le matériel. Morel, 2022 propose ainsi d'utiliser plusieurs circuits d'application de signal d'excitation de type oscillateurs, et de démultiplexer des signaux avec un unique intégrateur par fréquence. Le système de Morel, 2022, contrairement à celui de Jerger, 2012 permet de changer les fréquences dans la mesure où elles ne sont pas dictées par les composants physiques, et il évite la diaphonie entre les excitations, en prévoyant des lignes séparées pour les différentes fréquences.

16. Il n'est pas encore connu de réalisation pour lire plus de 100 qubits avec des circuits électroniques placés dans un cryostat, notamment du fait de la consommation énergétique du système. Or les codes correcteurs d'erreurs nécessitent plusieurs dizaines, voire centaines de qubits afin de réaliser un seul qubit logique "parfait". Cela nécessite donc de pouvoir lire plusieurs milliers de qubits, voire plus, pour mettre en place des ordinateurs quantiques performants.

17. Dans ce contexte, et pour résoudre les problèmes évoqués, il est proposé, selon certains principes connus, un dispositif quantique comprenant une pluralité de qubits, dans une enceinte de température basse du cryostat, et pour chaque qubit de la pluralité de qubits, un électromètre couplé audit qubit et soumis sur sa grille ou sur son drain à une excitation périodique pour transmettre à la boîte quantique de mesure de charge associée au qubit ladite excitation, ce qui permet d'extraire un signal de lecture d'un état courant du qubit, les signaux de lecture des qubits de la pluralité étant additionnés sur une ligne de lecture commune du dispositif quantique, puis transmis à un circuit de démultiplexage du dispositif quantique extérieur à ladite enceinte de température basse.

18. Ainsi, ces principes peuvent se décliner sous la forme d'une lecture de la charge par courant (l'électromètre quantique a alors une conductance qui varie en fonction de l'état du qubit qui lui est lié et il peut être un SET, ou un QPC, notamment), ou par tension si l'électromètre fournit une tension comme signal de sortie.

19. Mais le dispositif quantique est remarquable car les excitations périodiques transmises à un groupe de plusieurs électromètres du dispositif l'étant avec une fréquence identique à l'aide d'un moyen de génération synchronisé du dispositif quantique extérieur à ladite enceinte de température basse, le dispositif quantique comprend des moyens de déphasage et éventuellement d'atténuation en amplitude dans ladite enceinte de température basse introduisant des déphasages et éventuellement des atténuations d'amplitudes distinctes dans les excitations appliquées respectivement aux électromètres dudit groupe.

20. Grâce à ces caractéristiques, plusieurs qubits peuvent être interrogés avec une seule fréquence, ce qui permet, à bande passante égale, de multiplier le nombre de qubits lus simultanément, avec un nombre limité de câbles sortant du cryostat. L'empreinte des composants pour démultiplexer les signaux est faible, car une seule chaine de démodulation est nécessaire par fréquence, et permet donc d'interroger plusieurs qubits. Le multiplexage en phase et en amplitude peut être utilisé en parallèle d'un multiplexage fréquentiel, et le complète (le multiplexage en phase et en amplitude et le multiplexage en fréquence sont utilisés simultanément).

21. Ainsi, on lit plus d'un qubit par fréquence en attribuant la même fréquence d'excitation à chaque qubit, mais avec une phase et éventuellement une amplitude à chaque fois différente. Le signal de sortie composé de l'addition des courants de sortie des transistors Iₒᵤₜ a sa phase et son amplitude qui changent en fonction de l'état de chacun des qubits excités à la fréquence concernée. Finalement, cette information de phase et d'amplitude est extraite par l'utilisation d'une démodulation IQ. Les combinaisons d'états des qubits prennent alors la forme d'une constellation de symboles qu'il est possible d'interpréter, notamment par un décodage numérique.

22. Pour éviter les symétries, on peut introduire une forme ou une autre de singularité qui permet de supprimer les symétries et d'ainsi éviter les superpositions de combinaisons d'états (ou symboles) différentes dans l'information démodulée, et permet par conséquent d'interpréter celle-ci de manière univoque.

23. Par ailleurs, l'architecture a l'avantage de permettre un choix flexible des fréquences, celles-ci n'étant pas imposées par le matériel et pouvant être modifiée d'une utilisation à une autre, sans modifier le matériel.

24. Et selon l'invention, un seul câble pénétrant l'enceinte de température du cryostat est nécessaire (du moins pour une fréquence), puisque les moyens de déphasage et d'atténuation de l'amplitude sont à l'intérieur de l'enceinte de température, les moyens de génération de la tension étant quant à eux, classiquement à une température plus élevée, par exemple la température ambiante. Le fait qu'un seul câble pénètre l'enceinte de température est remarquable, car cela facilite la mise en place du circuit et améliore son bilan thermique. Le moyen de génération synchronisé est un générateur unique, ou un groupe de générateurs synchronisés entre eux.

25. De manière avantageuse et optionnelle :
2 6. - les moyens de déphasage et éventuellement d'atténuation de l'amplitude peuvent être des longueurs de câbles différentes, des déphaseurs réglables, des oscillateurs à injection ou des chaines d'inverseurs CMOS.
2 7. - les électromètres peuvent être répartis en plusieurs groupes, chaque groupe recevant une excitation avec une fréquence distincte de celles des autres groupes, et la ligne de lecture commune étant commune aux électromètres des différents groupes.
2 8. - chaque électromètre peut comprendre un transistor à un électron, les qubits étant des qubits de spin, l'excitation périodique étant appliquée à la grille du transistor ou plus généralement la grille de l'électromètre et le transistor ou plus généralement l'électromètre et le qubit associé étant couplés par un couplage capacitif entre leurs boites quantiques. Ainsi, le spin du qubit est converti en une charge puis un courant de sortie généré par couplage électrostatique capacitif est mesuré. Le spin du qubit est ainsi converti en une information de courant.
2 9. - les qubits peuvent être des qubits de spin, et chaque couple qubit et électromètre associé sont couplés capacitivement par des boites quantiques de l'un et de l'autre.

30. Les phases attribuées aux qubits peuvent l'être selon les principes suivants :
3 1. - les phases associées aux électromètres dudit groupe peuvent être essentiellement réparties régulièrement tous les 2π/n radians, n étant un entier naturel premier supérieur ou égal à 3, et la répartition des symboles associés dans le plan IQ est rendue secondairement irrégulière par une singularité dans ladite répartition qui constitue une perturbation dans la régularité sans remettre en cause l'existence de celle-ci.
3 2. - Par exemple, le nombre des électromètres du groupe peut être n-1, une quelconque des n valeurs 2π/n radians n'étant attribuée à aucun électromètre du groupe. Le fait qu'une des valeurs n'est pas attribuée est la singularité dans la répartition.
3 3. - Ou comme autre exemple, les signaux correspondant aux symboles à une seule valeur 1 (les phases associées aux électromètres) peuvent être répartis dans l'intervalle 0 à 2π radians selon une répartition de premier ordre (ou de premier abord) régulière mais comprenant, dans un ordre de grandeur inférieur (ou en deuxième analyse), un décalage de phase visant à supprimer la superposition entre la combinaison d'états, ou symbole ne comprenant que des 0 et la combinaison d'états, ou symbole ne comprenant que des 1 - Une implémentation particulière de ce principe, qui est un exemple non limitatif, est que le nombre des électromètres du groupe peut être n, les phases d'une paire de deux phases opposées l'une par rapport à l'autre par rapport à π radians sont décalées l'une vers l'autre par rapport aux valeurs qu'elles auraient eues pour une répartition des phases strictement régulière. Le décalage des valeurs est la singularité dans la répartition.
3 4. - Ou comme encore autre exemple, le nombre des électromètres du groupe peut être n, l'amplitude d'une des excitations au moins étant diminuée ou augmentée par rapport à au moins une autre. Les amplitudes sont multiplexées (variées pour chacun des qubits en fonction des besoins) afin de limiter les symétries de la répartition de phase choisie. Cette diminution ou augmentation est une singularité comme évoqué ci-dessus.

35. La présence d'une singularité permet, comme cela a déjà été dit, de supprimer les symétries et d'ainsi éviter les superpositions de combinaisons d'états (ou symboles) différentes dans l'information démodulée, et permet par conséquent d'interpréter celle-ci de manière univoque.
3 6. - Alternativement, les phases associées aux électromètres dudit groupe peuvent être essentiellement réparties régulièrement tous les π/n radians, n étant un entier naturel supérieur ou égal à 4, et étant le nombre maximum de qubits et d'électromètres, et leur répartition est rendue secondairement irrégulière si n est supérieur ou égal à 5.
3 7. - Alternativement encore, les amplitudes sont attribuées selon la règle à partir de n =1, pour n impair, la même amplitude est attribuée au qubit n et au qubit n+1 et les amplitudes sont attribuées à chaque nombre impair successif en divisant la précédente amplitude par 2, les phases associées aux électromètres dudit groupe étant successivement incrémentées de *π*/2 radians en passant d'un qubit au qubit suivant, ou prenant alternativement deux valeurs décalées de *π*/2.

38. D'autres caractéristiques optionnelles sont maintenant évoquées :
- ladite enceinte de température basse peut être l'enceinte de température des qubits. C'est alors l'enceinte de température minimale, et il est très avantageux que peu de câbles la traverse, eu égard aux enjeux énergétiques.
- ladite enceinte de température basse peut être une enceinte de température intermédiaire, les qubits étant dans une enceinte du cryostat qui est une enceinte de température plus basse que ladite enceinte de température basse et interne à celle-ci, et les moyens de déphasage et d'atténuation d'amplitude étant à l'extérieur de l'enceinte de température plus basse mais dans l'enceinte de température intermédiaire, qui renferme également un amplificateur pour amplifier le signal sur la ligne de lecture commune. On évoque ici un cryostat avec des enceintes successives de tailles décroissantes, l'enceinte la plus froide étant installée dans l'enceinte de température intermédiaire.
- le dispositif peut conserver, par exemple dans une mémoire informatique, une caractérisation préalable de la réponse du dispositif quantique à travers lesdits moyens de démodulation en quadrature aux combinaisons d'états possibles des qubits associés aux électromètres quantiques dudit groupe et à ladite fréquence identique pour ladite répartition donnée des déphasages, les moyens de discrimination utilisant ladite caractérisation préalable. Utiliser la caractérisation préalable qui a été obtenue avant l'exploitation et conservée pour l'exploitation du dispositif quantique permet d'interpréter l'information démodulée et d'identifier les combinaisons d'états des qubits lus pendant le fonctionnement du dispositif.

42. Les moyens de discrimination peuvent être numériques et effectuer des discriminations par région d'intérêt ou par recherche du plus proche voisin pour identifier les combinaisons d'états dans le plan complexe.

43. L'électromètre quantique peut être construit sur la base d'un transistor à un électron mais il peut aussi l'être sur la base d'un contact ponctuel quantique, les qubits étant des qubits de spin.

44. Le dispositif quantique peut comprendre, pour transmettre l'information en dehors d'un cryostat dans lequel sont placés les qubits et les électromètres quantiques (typiquement les SETs), jusqu'au circuit de démultiplexage qui est placé en dehors dudit cryostat, une ligne de transmission radiofréquences unique.

45. Le dispositif quantique peut comprendre sur la ligne de transmission une chaîne d'amplification d'une bande passante de 40 MHz, dont le rapport signal sur bruit en sortie est égal à 1,383 ou plus afin d'assurer une fidélité de lecteur de 99.99%, les moyens de démodulation ayant un temps de lecture de l'ordre de 1 µs.

46. Le dispositif quantique peut aussi comprendre sur la ligne de transmission un amplificateur à transimpédance par exemple à réseau capacitif, à retour de shunt, de type cascode régulé, ou de type push-pull, amplifiant les signaux de lecture des qubits du groupe et éventuellement d'autres qubits, notamment les qubits d'un autre groupe de qubits, les électromètres associés recevant une autre fréquence, avant leur transmission sous forme amplifiée au circuit de démultiplexage.

47. Les moyens de démultiplexage peuvent utiliser des moyens de démodulation en quadrature et effectuer alors une démodulation homodyne ou hétérodyne. Ils peuvent aussi comprendre une transformation de Fourier rapide menée après numérisation du signal de lecture.

### Brève description des dessins

48. L'invention sera mieux comprise et d'autres avantages apparaitront à la lecture de la description qui va suivre donnée à titre non limitatif et grâce aux figures annexées parmi lesquelles :
49. Les figures 1A et 1B sont des représentations d'un circuit de lecture de qubits selon les principes de l'invention.
50. La figure 2 montre un aspect particulier de l'invention.
51. La figure 3 montre un premier exemple d'exploitation de la lecture de qubits selon l'invention, dans un cas avec 2 phases différentes pour une fréquence, placées de manière simple.
52. La figure 4 montre la mise en œuvre d'un aspect d'un mode de réalisation de l'invention dans le cas de la figure 3.
53. La figure 5 montre, à gauche, une mise en œuvre pour 3 phases qui n'est pas privilégiée, mais qui est utilisée pour l'explication, et à droite un exemple de lecture de qubits selon l'invention, pour 2 phases et fondée sur la répartition présentée en partie gauche pour 3 phases.
54. La figure 6 montre un exemple de constellation des combinaisons possibles pour une mise en œuvre particulière avec 4 phases par fréquence.
55. La figure 7 montre un exemple de constellation des combinaisons possibles pour une mise en œuvre particulière avec 6 phases par fréquence.
56. La figure 8A montre un autre exemple de lecture de qubits selon l'invention, mais avec trois phases pour une fréquence, et une mise en œuvre différente de celle présentée aux figures 3 à 7.
57. La figure 8B montre un autre exemple de lecture de qubits selon l'invention, avec à nouveau trois phases pour une fréquence, et une mise en œuvre différente de celle présentée aux figures précédentes.
58. La figure 8C montre un autre exemple de répartition des combinaisons d'états composées d'un unique 1 dans le plan I,Q.
59. La figure 8D montre encore un autre exemple de choix des excitations, et la figure 8E la constellation de lecture associée dans le plan IQ; et les figures 8F et 8G conjointement encore un autre exemple.
60. Les figures 9 à 12 montrent quatre variantes techniques de mise en oeuvre d'un circuit de lecture de qubits selon l'invention.
61. La figure 13 montre une variante de circuit de connexion des transistors à un électron de la figure 1A ou de la figure 1B.

### Description détaillée des dessins

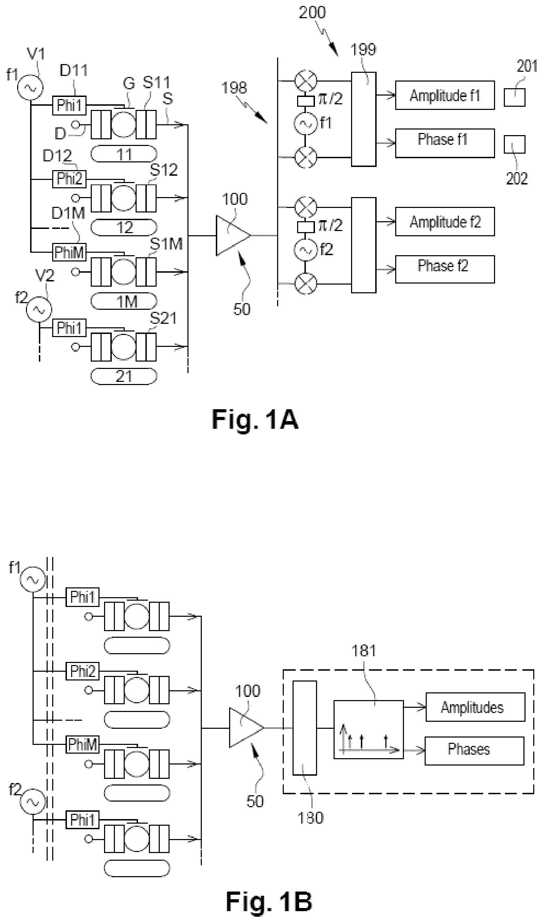

62. [Fig. 1A] En référence à la figure 1A, on a représenté un circuit de lecture de qubits selon un mode de réalisation de l'invention. Il est basé sur une lecture de charge, avec démultiplexage fréquentiel.

63. Il est construit autour de qubits de spin sur silicium, placés dans un cryostat à très basse température, et dans l'exemple décrit, moins d'un kelvin (1 K). Les qubits de spin sont chacun couplés capacitivement à un transistor à un seul électron (Single Electron Transistors ou SET), placé à son contact dans le cryostat.

64. On a représenté des qubits, formant ici deux groupes, et référencés pour le premier groupe qubit 11, qubit 12, ... qubit 1M et pour le deuxième groupe qubit 21, ... mais l'invention utilise un nombre plus grand de qubits, par exemple de l'ordre de la dizaine, de la centaine ou plus, regroupés en un nombre n de groupes comprenant chacun un nombre M de qubits, M étant un entier naturel au moins égal à 2, qui peut varier d'un groupe à l'autre. Le nombre n de groupes est au moins 1.

65. Les SETs associés, un par qubit, sont respectivement référencés SET S11, SET S12, ... SET S1M et SET S21 .... Ils possèdent chacun une grille G ou plusieurs grilles, ainsi qu'une source S et un drain D, qui sont identifiés sur la figure pour le SET S11. En fonction du spin du qubit (c'est-à-dire son état, s'agissant d'un qubit de spin), le SET voit sa conductance varier. Cet effet se produit par une interaction entre les boites quantiques respectives du qubit et du SET.

66. Les drains D des SETs sont reliés à un ou des potentiels constants (ou éventuellement non constants), et par conséquent, en fonction du spin du qubit, le SET délivre un courant sur sa source S, ou n'en délivre pas ou encore délivre en fonction des circonstances l'un ou l'autre de deux niveaux de courant distincts et tous les deux non nuls.

67. Les groupes de qubits sont aussi des groupes de SETs, chaque qubit étant en effet relié à un SET qui lui est spécifiquement dédié.

68. Les SETs sont excités en tension par des générateurs de tension, typiquement sinusoïdale (mais pouvant être carrée ou triangulaire), comme cela est représenté en partie gauche de la figure. Chaque SET est excité de manière séparée par sa grille G (c'est ce qui est présenté sur la figure) ou par son drain D (non représenté). Les SETs d'un même groupe sont excités avec une même fréquence, générée par un générateur de tension commun à ces SETs (ou éventuellement par des générateurs distincts mais synchronisés). Il y a ainsi n générateurs de tension sinusoidale de fréquences différentes, à raison d'un tel générateur (ou ensembles de générateurs distincts mais synchronisés) par groupe de SETs. Ainsi, sur la figure 1A, les SETs S11, S12 ... et S1M sont excités par un générateur V1 de tension sinusoïdale de fréquence f1, et le SET S21 est excité par un générateur V2 de tension sinusoïdale de fréquence f2.

69. Les n générateurs V1, V2 ... sont placés, dans le mode de réalisation présenté, à température ambiante et déployant des signaux de quelques mV, à des fréquences allant de 1 MHz jusqu'à environ 100 MHz. Ils sont reliés chacun par une ligne de transmission qui pénètre dans le cryostat, aux SET des qubits du groupe de qubits qui reçoivent la fréquence générée par le générateur concerné. Néanmoins, il est aussi possible, dans une variante, de placer les n générateurs dans le cryostat, ce qui permet de ne pas faire pénétrer des câbles pour l'excitation depuis l'extérieur du cryostat vers son espace interne. L'invention propose néanmoins que les déphaseurs soient à un étage de température plus faible que les générateurs V1, V2 ...

70. Un décalage de phase (ou simplement phase, par facilité de langage) possiblement associé à une atténuation d'amplitude, spécifiques à chaque SET est inséré entre le générateur de son groupe et la grille du SET particulier, par des déphaseurs D11, D12, ... D1M et D21 .... Ces décalages distincts sont du même nombre que les SETs du groupe concerné, qui pour le premier groupe qui est représenté sur la figure est au nombre de M comme cela a déjà été dit. Des phases Phi1, Phi2... et PhiM (comprises entre 0 et 2π) sont ainsi insérées entre le générateur V1 et respectivement chacun des SETs S11... S1M. D'autres phases, identiques aux phases Phi1, Phi2 et PhiM ou différentes de celles-ci, sont insérées entre le générateur V2 et les SETs du deuxième groupe, dont en premier lieu sur la figure, le SET 21, seul représenté par facilité de représentation. D'autres phases sont encore insérées, SET par SET entre les générateurs de tension d'autres fréquences, différentes de f1 et f2, et les SETs d'autres groupes de SET, non représentés sur la figure. Des déphaseurs passifs (comme par exemple une différence de longueur d'interconnexion telle qu'une longueur de câble, par exemple coaxial, supplémentaire d'une longueur induisant un déphasage et éventuellement une atténuation d'amplitude significative) sont, dans un mode de réalisation, utilisés pour construire très simplement les déphaseurs D11, D12, ... D1M et D21 .... Les déphaseurs peuvent aussi être des oscillateurs à injection ou des chaines d'inverseur CMOS.

71. Les courants de sortie des SETs, apparaissant à leur source S et qui sont de l'ordre du nanoampère (nA), sont collectés et additionnés sur une ligne conductrice 50 à grande proximité des SETs, dans le cryostat des qubits. Cette ligne est commune à tous les qubits d'un groupe de qubits (ici les qubits 11, 12, ... 1M pour le premier groupe), voire dans l'exemple représenté à la figure, aux qubits de tous les groupes (ici les qubits 11, 12, ... 1M, 21 ...).

72. Le courant résultat de la somme des courants collectés et additionnés sur cette ligne est amplifié par une chaîne d'amplification 100 (comprenant un ou plusieurs amplificateurs), puis lu par un circuit de démodulation 200 présenté en partie droite de la figure. Le pas temporel de lecture est de l'ordre de la microseconde (µs), en lien avec l'ordre de grandeur du phénomène de décohérence des qubits de spin sur silicium.

73. Ainsi, de par ce qui vient d'être présenté il est mis en oeuvre, sur la ligne de transmission 50 lors de la collecte des courants, un multiplexage en phase, et également, s'il y a au moins deux groupes de qubits ce qui est le cas sur la figure, un multiplexage en fréquence en plus du multiplexage en phase. Plusieurs qubits sont excités avec une tension à la même fréquence, mais avec une phase spécifique à chaque qubit. De telle sorte, le nombre de qubits par fréquence est M.

74. Le choix des fréquences comme précédemment et, et c'est nouveau et original, le choix de répartition des phases et des atténuations d'amplitudes sont flexibles, et peuvent être décidés après fabrication du circuit, et également modifiés pour un même circuit, puisqu'ils ne sont pas imposés par les composants électriques notamment les composants placés dans le cryostat.

75. La ou les chaînes de démodulation formant le circuit de démodulation 200 peuvent être construites sous forme intégrée ou non intégrée et elles peuvent être des chaînes par lesquelles le démultiplexage est analogique ou numérique, le résultat étant finalement numérisé dans les variantes proposées.

76. La figure 1A montre des chaines distinctes par fréquence (une chaine pour f1 en partie haute de figure, puis une chaine pour f2, et d'autres chaines pour les autres fréquences ne sont pas représentées, mais peuvent être présentes), dans lesquelles des mélangeurs génèrent la composante I et la composante Q à l'aide de deux ondes de fréquence f1 déphasées l'une de l'autre de 90°, constituant ainsi des moyens de démodulation en quadrature 198. Les composantes I et Q sont ensuite traitées, pour chaque fréquence, par des convertisseurs analogique-numérique 199.

77. Le circuit de démodulation 200 peut être placé à différentes températures : la température des qubits (moins de 1K), la température ambiante (de l'ordre de 300 K), ou une température intermédiaire (par exemple 4K), auquel cas il peut être avantageux, sans que ce soit obligatoire, de placer aussi dans l'enceinte de l'étage de température de cette température intermédiaire les générateurs de fréquence V1, V2, ..., pour rendre disponible leur signal aux fins d'effectuer les mélanges nécessaires pour extraire les composantes I et Q.

78. Le mode de réalisation présenté combine de plus les multiplexages en phase et en fréquence. Pour n fréquences différentes, avec M phases différentes on peut lire n*M qubits en ne générant que n fréquences et en ayant seulement n chaînes de démodulation IQ, à savoir une pour chaque fréquence.

79. Il peut n'y avoir qu'un seul câble de sortie de l'étage de température le plus froid pour n x M qubit, cette sortie pouvant se faire avant ou après la chaîne d'amplification 100, ou entre deux segments successifs de celle-ci.

80. Il y a peu de diaphonie (cross talk en anglais) entre les qubits car il y a une séparation physique des excitations, qui se font par des interconnexions distinctes portant les déphaseurs D11, D12, ... D1M, D21 ..., différents pour chaque qubit, même au sein d'un même groupe de qubits excités à la même fréquence.

81. La chaîne d'amplification 100 comprend un amplificateur à transimpédance (TIA) (qui convertit un courant en une tension) placé par exemple à la même température que les qubits, c'est-à-dire dans le mode de réalisation décrit moins de 1 K. Dans le mode de réalisation de la figure 1A (ou figure 1B), le gain de la chaine de lecture est entièrement réalisé par le TIA qui est capable d'amplifier le courant de sortie des SETs qui est de l'ordre de quelques nA. Pour cela le TIA a un gain de l'ordre de 1 000 000 V/A ou plus. Il a par ailleurs, compte tenu du temps de lecture de l'ordre de la µs, une bande passante de l'ordre de quelques dizaines de MHz. On choisit un TIA à faible consommation (de l'ordre d'une centaine de µW), ce qui permet de le placer dans le cryostat au plus proche des qubits, à la même température que ceux-ci, c'est-à-dire à une température de l'ordre de 100 mK. On choisit naturellement un TIA à faible bruit. Une architecture de TIA dite « capacitive feedback » comme divulguée par Razavi, 2000 est utilisée dans une variante particulièrement intéressante.

82. Le signal sur la ligne de transmission radiofréquences 50, avant démodulation, mais après conversion par le TIA est une tension de sortie.

83. La démodulation IQ extrait les composantes complexes I et Q du signal et les transmets à un convertisseur analogique numérique 199 qui permet de placer l'amplitude et la phase du signal dans le plan complexe. Celles-ci se présentent sous la forme de constellations de points appelés symboles correspondant à des combinaisons des états des qubits excités à la fréquence utilisée pour la chaîne de démodulation concernée. Ces constellations seront discutées plus loin.

84. Des caractérisations préalables de la réponse, vue par les circuits de démodulation 198, des qubits aux excitations aux différentes fréquences f1, f2 ... en fonction des états des qubits ont été stockées dans des mémoires 201 (ou adresse mémoire) du circuit de démultiplexage 200 associées à chaque fréquence f1, f2, ... Ces caractérisations préalables sont comparées, par des moyens de discrimination 202, aux composantes complexes I et Q mesurées pour reconnaître la combinaison d'états courante (le symbole courant) des qubits excités à la fréquence concernée. Le moyen de discrimination 202 peut être un ASIC (circuit intégré propre à une application) ou un DSP (processeur de signal numérique).

85. Un moyen de discrimination similaire (non représenté), qui peut être le même ASIC ou le même DSP, est prévu pour traiter les informations obtenues par la chaine de démodulation s'intéressant à la fréquence f2. Il permet de déduire du signal multiplexé l'état du qubit 21 et d'autres qubits non représentés sur la figure. Il en est de même pour les autres fréquences utilisées (non représentées).

86. [Fig. 1B] En référence à la figure 1B, on a représenté un circuit de lecture de qubits selon un deuxième mode de réalisation de l'invention. Il est basé sur une lecture de charge, avec démultiplexage fréquentiel, et reprend des éléments du circuit de la figure 1A.

87. Les qubits, les SETs, les générateurs et les déphaseurs sont agencés et reliés entre eux comme en figure 1A. Une chaîne d'amplification 100 est présente en sortie des SETs et mène cette fois-ci à un convertisseur analogique vers numérique 180, qui numérise le signal de sortie sur toute la bande passante. Ainsi, le convertisseur analogique vers numérique 180 traite les signaux aux différentes fréquences f1, f2, ... On choisit pour cela un convertisseur dont la bande passante s'étend jusqu'à une fréquence double de la limite maximale de la bande passante de la chaine d'amplification (le TIA, et/ou un amplificateur tension/tension).

88. La sortie du convertisseur analogique vers numérique 180 est prise en charge et traitée par un module de transformée de Fourier rapide 181, dans un ASIC ou un DSP, qui fournit (ou projette) une amplitude et une phase dans le plan complexe séparément pour chacune des fréquences f1, f2, ....

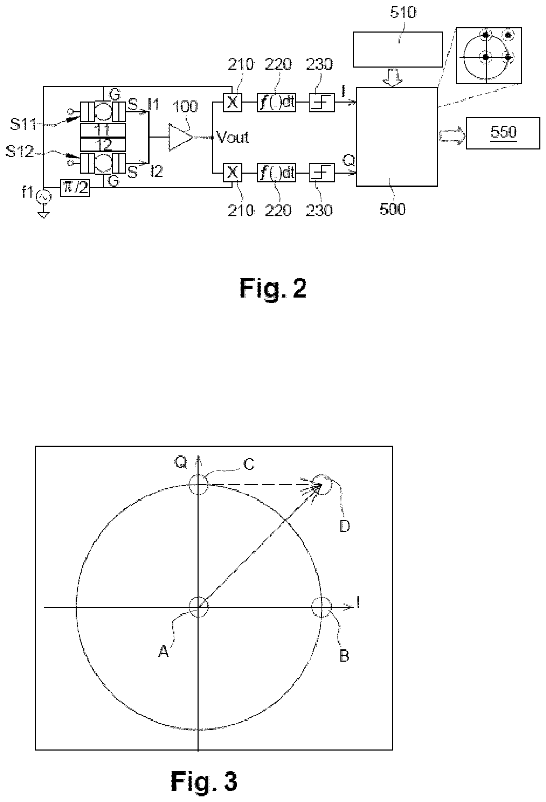

89. [Fig. 2] En figure 2, on a représenté la démodulation IQ utilisée, pour le cas de deux phases séparées de π/2, en ce qui concerne une fréquence unique f1. D'autres fréquences peuvent être traitées par des circuits de démodulation parallèles en aval de l'amplificateur à transimpédance TIA, ce qui permet alors de lire plusieurs paires de qubits disposés en amont du TIA, avec une fréquence par paire de qubits.

90. En s'arrêtant sur la figure 2 où une seule fréquence est utilisée, une même tension sinusoïdale d'excitation à la fréquence f1 est générée et envoyée sur la grille des deux SETs du système. Pour l'un des transistors, elle est appliquée directement, à la grille du SET couplé au qubit 1. Pour l'autre transistor, elle est déphasée d'une autre valeur Phi avant d'être appliquée à la grille du SET couplé au qubit 2. Ici, on a choisi la valeur Phi = *π*/2.

91. Comme évoqué en introduction, les SETs présentent des comportements différents en fonction de l'état du qubit qui leur est lié. Si le qubit lié est en état 1, le SET transmet sur sa sortie sous forme de courant l'excitation apportée sur sa grille, en reproduisant notamment la fréquence f1 et la phase (ici, 0 ou *π*/2). Si le qubit lié au SET est en état 0, le SET ne transmet pas son excitation, et aucun courant n'est présent sur la sortie du SET. La présence ou l'absence du couple fréquence d'excitation et phase spécifique à la sortie de chaque SET est ainsi dépendante de l'état du qubit lié au SET.

92. Les courants des SETs sont sommés puis la somme est appliquée à l'entrée de la chaîne d'amplification 100 comprenant un amplificateur à transimpédance TIA qui la convertit en tension et amplifie le signal.

93. L'information constituée par l'état de chaque qubit est ensuite extraite de ce signal. On utilise deux voies avec une voie extrayant l'information contenu dans le signal qui n'a pas été déphasé et qui est classiquement appelé signal I et une voie extrayant l'information contenu dans le signal qui a subi un déphasage en quadrature (de *π*/2 ou - *π*/2) et qui est appelé classiquement signal Q.

94. La figure 2 tire parti du fait que la phase apportée au SET S12 est *π*/2, ce qui fait qu'un même déphaseur est utilisé dans deux circonstances distinctes (le déphasage d'un SET par rapport à l'autre, et ensuite la démodulation IQ), mais si cette phase apportée au SET S12 est différente, il convient d'avoir un déphaseur de *π*/2 pour la démodulation et un autre, distinct, de la phase Phi pour le SET S12 (ce qui est envisagé en figure 1A, avec néanmoins un nombre de phases plus élevé).

95. Le démodulateur utilise deux chaines en série constituées chacune d'un multiplieur 210, d'un filtre intégrateur 220 ainsi que d'un comparateur 230 afin de convertir l'information contenue dans les deux signaux (I et Q) en deux mots binaires à 1 bit chacun. Un convertisseur analogique numérique à 1 bit est ainsi constitué par la connexion en série du multiplieur, d'un intégrateur et d'un comparateur. Au début de la chaine sont appliqués le signal amplifié apporté par le TIA et la tension sinusoïdale de référence (déphasée l'un par rapport à l'autre de *π*/2) à laquelle il est multiplié, et en sortie de la chaine, l'information apportée simultanément par les deux comparateurs 230 fait l'objet d'un dénombrement pendant un temps suffisant puis est décodée par un comparateur numérique de seuil 500 utilisant des tables de correspondance 510, par exemple par une extraction de type région of interest (région d'intérêt), permettant de déduire de manière univoque et fiable la combinaison courante 550 des états des qubits 11 et 12. Le comparateur numérique de seuil est mis en œuvre sous la forme d'un ASIC ou un DSP, et constitue un moyen de discrimination des états des qubits excités à la fréquence f1.

96. Plus dans le détail, le signal en sortie du TIA (Vₒᵤₜ) est multiplié par les mêmes signaux d'excitation (à la phase près) que ceux appliqués sur les SETs respectifs, ce qui permet de tester les deux voies pour connaître la présence ou l'absence dans celle-ci de la fréquence d'excitation. Si la fréquence est présente dans Vₒᵤₜ, la sortie du multiplieur 210 correspondant présente une tension qui a une composante continue en plus d'une composante sinusoïdale. Si la fréquence est absente, alors en sortie du multiplieur se trouve un signal sinusoïdal sans tension continue (voire un signal nul).

97. L'intégrateur 220 intègre la composante continue de la tension, dans le cas où celle-ci est présente, sous la forme d'une rampe en sortie qui finit par atteindre un seuil calibré dans le comparateur 230 dont la sortie passe d'un niveau haut (0) à un niveau bas (1). Si aucune tension continue n'est présente en sortie du multiplieur, alors la sortie de l'intégrateur n'atteint pas le seuil du comparateur dont la sortie reste à 0 (niveau haut).

98. L'état des qubits s'exprime ainsi en sortie des deux comparateurs sous forme de deux niveaux de tension pouvant être interprétés comme deux niveaux logiques et donc deux mots binaires. On compare les mots binaires générés avec des seuils préétablis stockés dans la table de correspondance 510 pour déterminer les états des qubits 550.

99. [Fig. 3] Une constellation dans le plan complexe pour deux phases par fréquence est présentée en figure 3. Ainsi, deux signaux d'excitation à la même fréquence sont envoyés sur respectivement un premier et un deuxième SET, mais avec une différence de phase entre les deux signaux. La figure représente l'espace complexe IQ. La première phase est prise par convention à 0 radian, la seconde phase quant à elle est dans ce mode de réalisation à *π*/2 radians. Les signaux peuvent être représentés par des points appelés symboles dans le plan IQ ou comme des vecteurs I+jQ.

100. Il y a donc quatre combinaisons d'états possibles selon que le premier qubit est à l'état 0 ou 1 et que le deuxième qubit est aussi à l'état 0 ou 1. La figure montre le signal pour ces différentes possibilités.

| | Qubit1 = 0 | Qubit1 = 1 |
|---|---|---|
| Qubit2 = 0 | Signal A | Signal B |
| Qubit2 = 1 | Signal C | Signal D |

101. La phase et l'amplitude de la somme des signaux de sortie des différents SET (Iₒᵤₜ en figure 1A) dépendent ainsi de l'état des qubits, sous la forme d'une addition de nombres complexes ou de vecteurs. Ainsi, la figure 3 montre que D = B + C.

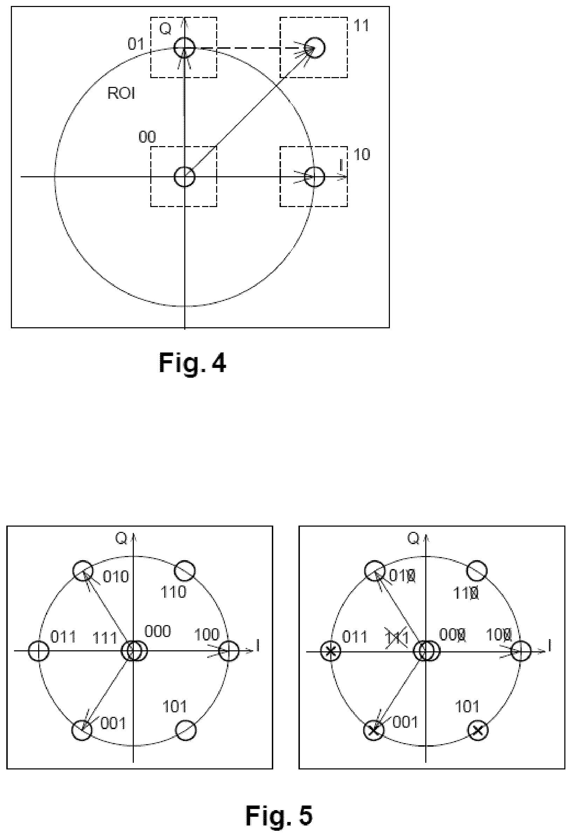

102. [Fig. 4] Les combinaisons d'états sont, dans un mode de réalisation, discriminées dans le plan complexe par différentes techniques qui reposent sur une calibration préalable de la constellation de sortie par l'application à de multiples occurrences de chaque combinaison d'états en entrée. A partir de cette constellation déterminée de manière statistique, on détermine, pour chaque combinaison d'états, une manière univoque de l'identifier dans le signal démodulé en condition d'exploitation du dispositif quantique.

103. Une méthode est d'utiliser des limites dans le plan complexe, par la technique de la région d'intérêt, ou « Region Of Interest » en abrégé ROI. La ROI peut utiliser des limites carrées, circulaires ou elliptiques, ou encore n'importe quelle forme pouvant se révélée avantageuse, dans le plan complexe : à l'intérieur de ces courbes fermées définissant des régions du plan, un signal positif indique la présence de la combinaison d'états associée à la région du plan à l'issue de la caractérisation préalable. La taille caractéristique des régions du plan complexe dans la technique ROI dépend directement de la fidélité de lecture recherchée, du bruit de lecture et du temps d'intégration du signal. Il existe donc un compromis entre le nombre de qubits lus simultanément et la fidélité de chaque lecture, pour un TIA et un temps de lecture donnés.

104. [Fig. 5] Si le nombre de SETs et de qubits est plus grand, et il y a alors m phases différentes, il y a 2^m (puissance m de 2) combinaisons d'états possibles.

105. Si la répartition des phases choisie présente une symétrie (ce qui est possible dès qu'on utilise deux phases, mais cela a été évité en figures 2 à 4), des combinaisons d'états se superposent, ce qui ne permet plus de lire l'intégralité de l'information présente dans les qubits. Pour surmonter cette difficulté, il est mis en œuvre des schémas de répartition des phases et des amplitudes, pour éliminer ou réduire les symétries dans les constellations de combinaisons d'état et ainsi lire l'intégralité de l'information présente.

106. Dans un mode de réalisation, le nombre de phases différentes est un nombre inférieur de la valeur 1 (c'est-à-dire inférieur d'une unité, ou résultant de la différence du nombre choisi et du nombre 1) à un nombre premier choisi supérieur ou égal à 3 (3, 5, 7, 11, ...).

107. Une fois ainsi déterminé le nombre de phases, celles-ci sont équi-réparties dans l'intervalle 0 à 2π autour du cercle trigonométrique, mais comme si une phase supplémentaire était prévue, et que leur nombre était effectivement égal au nombre premier choisi. Une position prévue est donc laissée inoccupée.

108. Ainsi, si le nombre premier utilisé est p, on prévoit une équirépartition avec un pas de 2π/p radians, et on ne met en place, sur cette répartition, que p-1 phases, une des places étant inoccupée, par exemple la dernière.

109. Grâce à cette méthode, la combinaison d'états composée uniquement de 0, et la combinaison d'états uniquement composé uniquement de 1 sont distinctes, du fait de l'inoccupation d'une des places, et toutes les combinaisons comprenant des 0 et des 1 sont aussi distinctes, du fait du caractère premier du nombre choisi.

110. Cela est illustré sur la figure 5 pour p = 3. La figure montre, à gauche, la constellation de combinaisons d'états envisageable tant que toutes les places définies pour 3 phases sont occupées. Il est possible, en laissant inoccupée l'une ou l'autre des 3 places, ce qui est fait en partie droite de la figure, d'obtenir dans le plan complexe un symbole distinct pour chaque combinaison d'états. Sur la figure les symboles 010, 110, 000 et 100 sont utilisés, les symboles 011, 001, 111 et 101 n'apparaissant plus, alors que si toutes les positions de l'équirépartition avaient été utilisées, les symboles 000 et 111 auraient été superposés, ce que l'on ne souhaite pas. Le troisième chiffre est toujours à 0, et les quatre symboles apparaissant dans la constellation sont 01 dans le cadran en haut à gauche, 11 dans le cadran en haut à droite, 00 au centre du plan et 10 sur l'axe des abscisses du côté positif.

111. Il s'agit là d'une alternative à la répartition proposée en figure 3, qui avait aussi cette propriété de discriminer les combinaisons pour deux phases.

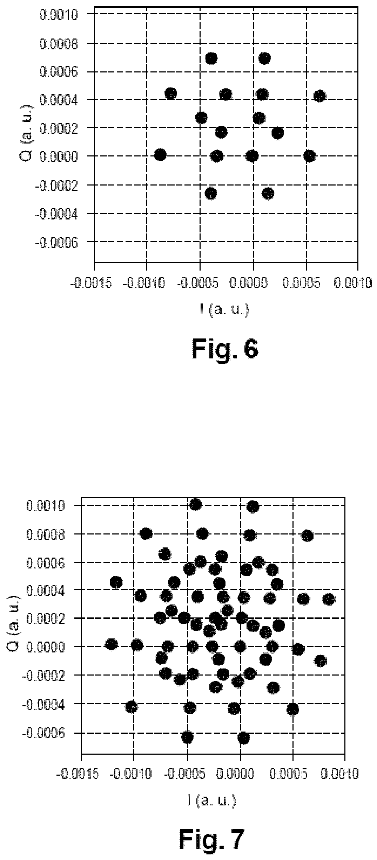

112. [Fig. 6] Cela est également illustré en figure 6 pour p = 5, et une utilisation de 4 phases, 5 étant un nombre premier comme on le sait. On a représenté la constellation des combinaisons d'états possibles avec 4 phases par fréquence en suivant une répartition équi-répartie à 5 phases.

113. Pour cette figure, on a de plus choisi un gain de l'amplificateur à transimpédance de 10⁶ V/A, une largeur de bande de l'amplificateur de 40 MHz, une intensité des transistors à un électron de 1 nA, et un bruit équivalent en entrée d'une valeur de 0,1.10^-27 A²/Hz. On constate que les symboles sont bien distincts et ne peuvent pas être confondues.

114. Le nombre de phases implémentées pour une fréquence donnée est essentiellement limité par le bruit de la chaîne d'amplification. En effet, l'écart-type ou la dispersion de chaque symbole et donc le risque qu'ils se superposent en partie sont liés au bruit de la chaîne d'amplification, ainsi qu'au temps de lecture.

115. [Fig. 7] La figure 7 montre une constellation 6 phases par fréquence en suivant une répartition équi-répartie pour 7 phases (7 étant un nombre premier comme déjà mentionné), à nouveau pour un gain de l'amplificateur à transimpédance de 10⁶ V/A, une largeur de bande de l'amplificateur de 40 MHz, une intensité des transistors à un électron de 1 nA, et un bruit équivalent en entrée d'une valeur de 0,1.10^-27 A²/Hz).

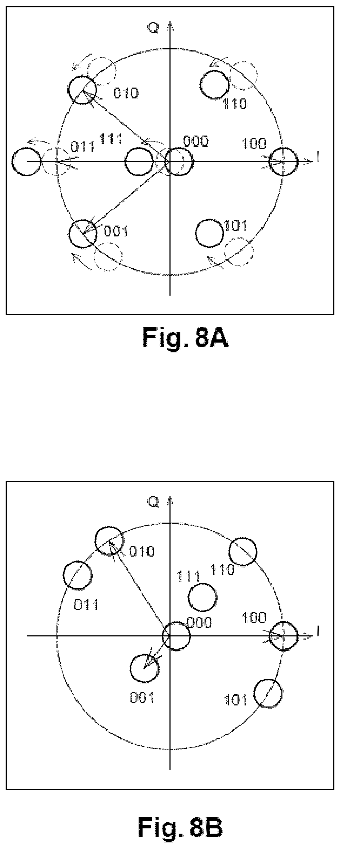

116. [Fig. 8A] Dans un autre mode de réalisation, illustré en figure 8A, les signaux correspondant aux symboles à une seule valeur 1 sont répartis dans l'intervalle 0 à 2π radians selon une répartition de premier ordre (ou de premier abord) régulière mais comprenant, dans un ordre de grandeur inférieur (ou en deuxième analyse), un décalage de phase visant à supprimer la superposition entre les symboles ne comprenant que des 0 et ne comprenant que des 1.

117. Le nombre de qubits différents est cette fois-ci un nombre premier supérieur ou égal à 3 (3, 5, 7, 11, ...), et les signaux correspondant aux symboles à une seule valeur 1 sont équi-répartis dans l'intervalle 0 à 2π autour du cercle trigonométrique (avec des amplitudes égales), toutes les places ainsi définies étant occupées par un qubit. Ainsi, si le nombre premier est p, on prévoit une équirépartition avec un pas de 2π/p radians, et on met en place, sur cette répartition, les p signaux correspondant aux symboles à une seule valeur 1, toutes les places étant occupées.

118. Ainsi, toutes les combinaisons comprenant à la fois des 0 et des 1 sont distinctes, du fait du caractère premier du nombre choisi.

119. Le décalage évoqué ci-dessus est mis en oeuvre pour distinguer les combinaisons restantes, à savoir la combinaison qui ne comprend que des 0, et celle qui ne comprend que des 1, qui, de par les symétries, risquent d'être superposées si aucune mesure n'est prise.

120. Ainsi, certains symboles à une seule valeur 1 sont légèrement déplacés, de telle sorte que les symboles ne comprenant que des 0 et ne comprenant que des 1 ne soient plus superposés.

121. Une illustration est présentée en figure 8A pour le cas où p = 3, pour lequel on a déplacé (à partir de la configuration de la partie gauche de la figure 5) le long du cercle unitaire, pour les éloigner du point (I = 1 ; Q = 0), les deuxième et troisième symboles à une seule valeur 1, ce qui a pour conséquence un déplacement des combinaisons d'états 010 et 001 le long du cercle unitaire et des combinaison d'états 110, 011 et 101 en dehors de celui-ci.

122. Ces déplacements ne remettent pas en cause la possibilité de distinguer ces combinaisons d'états des autres, et a également pour conséquence l'apparition d'un décalage entre les combinaisons d'états 111 et 000 (c'est 111 qui se déplace), ce qui permet de les distinguer, ce qui n'était pas possible sans le décalage mis en oeuvre pour les qubits 2 et 3.

123. Alternativement, on pourrait simplement décaler plus qu'une seule paire de phases. Ou bien l'une des phases vers l'autre, en laissant l'autre phase inchangée.

124. La figure fournie présente en effet le cas décrit, mais l'idée derrière est surtout l'apport d'une singularité quelconque dans la répartition.

125. [Fig. 8B] Dans un autre mode de réalisation, illustré en figure 8B, les signaux correspondant aux symboles à une seule valeur 1 sont répartis dans l'intervalle 0 à 2π radians selon une répartition régulière, mais comprenant un décalage d'amplitude visant à supprimer la superposition entre le symbole ne comprenant que des 0 et le symbole ne comprenant que des 1.

126. Le nombre de signaux correspondant aux symboles à une seule valeur 1 différents (c'est-à-dire le nombre de qubits) est à nouveau un nombre premier supérieur ou égal à 3 (3, 5, 7, 11, ...), et les signaux correspondant aux symboles à une seule valeur 1 sont équi-répartis (comme en figure 8A), en première analyse, dans l'intervalle 0 à 2π autour du cercle trigonométrique, toutes les places ainsi définies étant occupées par un signal.

127. Un décalage d'amplitude est introduit sur un des signaux correspondant à un symbole à une seule valeur 1, de telle sorte que les symboles ne comprenant que des 0 et ne comprenant que des 1 ne soient plus superposés.

128. Une illustration est présentée en figure 8B pour le cas où p = 3, pour lequel on a déplacé en dehors du cercle unitaire, pour le rapprocher du point (I = 0 ; Q = 0), le signal 001, ce qui a pour conséquence un déplacement des symboles des combinaisons d'états 011, 101 et 111.

129. Ces déplacements ne remettent pas en cause la possibilité de distinguer ces combinaisons d'états des autres, et a également pour conséquence l'apparition d'un décalage entre les combinaisons d'états 111 et 000 (c'est 111 qui se déplace), ce qui permet de les distinguer, ce qui n'était pas possible sans le décalage mis en oeuvre pour le qubit 3.

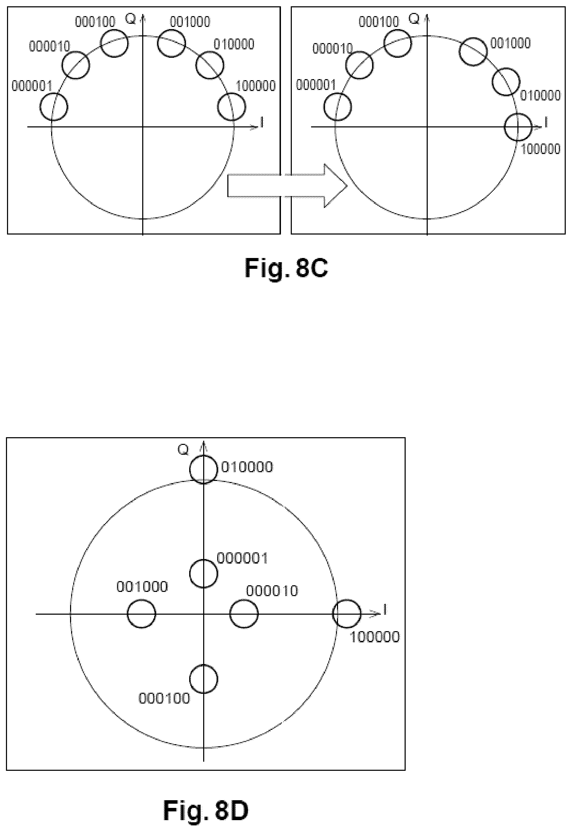

130. [Fig. 8C] Dans un autre mode de réalisation, quatre phases sont réparties de manière régulière sur une seule moitié du cercle trigonométrique en choisissant des phases égales à *π*/8, 3*π*/8, 5*π*/8, 7*π*/8 pour chacun des signaux correspondant à un symbole à une seule valeur 1. De par la répartition sur une moitié du cercle trigonométrique, on casse la symétrie liant la combinaison d'états 0..00 et la combinaison d'états 1..11. En plus, de par la répartition en demi-cercle, les amplitudes ne s'annulent plus entre-elles, mais s'additionnent, ce qui résout les problèmes de symétries liés à un choix de 4 phases par fréquence.

131. Afin de généraliser cette technique de répartition sur demi-cercle trigonométrique à un maximum de nombre de phases, il est procédé à de petits ajustements. En effet, au-delà de 4 phases par fréquence, il est nécessaire d'induire un décalage, par exemple dans la répartition des phases d'un seul quart de cercle trigonométrique. Ou bien, comme précédemment pour une répartition sur cercle complet, il est possible d'induire un décalage sur une ou plusieurs phases. Ainsi, toute symétrie est cassée et la répartition est normalement compatible pour tout nombre de phases. Il faut aussi éviter, lors d'un placement d'un nombre impair de phases, de placer une phase au centre du demi-cercle.

132. La figure 8C montre une répartition sur demi-cercle equi-répartie désaxée.

133. Ainsi, comme cela a déjà été dit, on lit plus d'un qubit par fréquence en attribuant la même fréquence d'excitation à chaque qubit, mais avec une phase et une amplitude à chaque fois différente. Le signal de sortie composé de l'addition des courants de sortie des transistors Iₒᵤₜ a sa phase et son amplitude qui changent en fonction de l'état de chacun des qubits excités à la fréquence concernée. Finalement, cette information de phase et d'amplitude est extraite par l'utilisation d'une démodulation IQ. Les combinaisons d'états des qubits prennent alors la forme d'une constellation de symboles qu'il est possible d'interpréter, notamment par un décodage numérique.

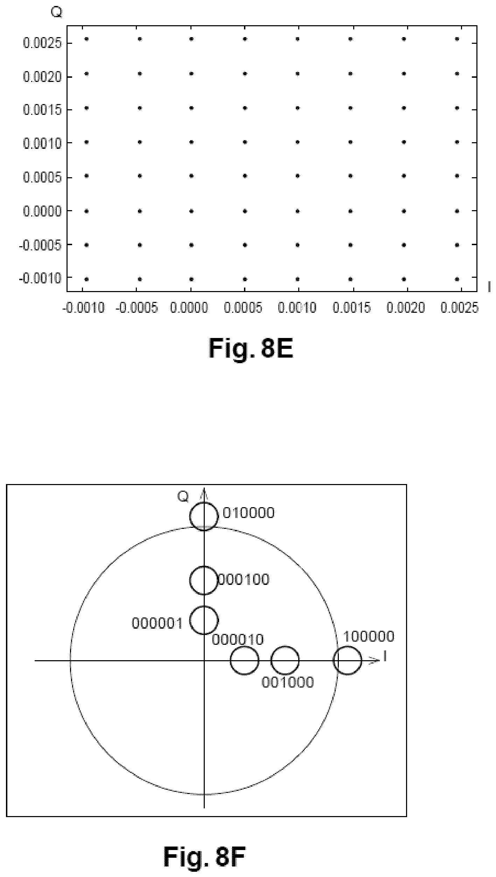

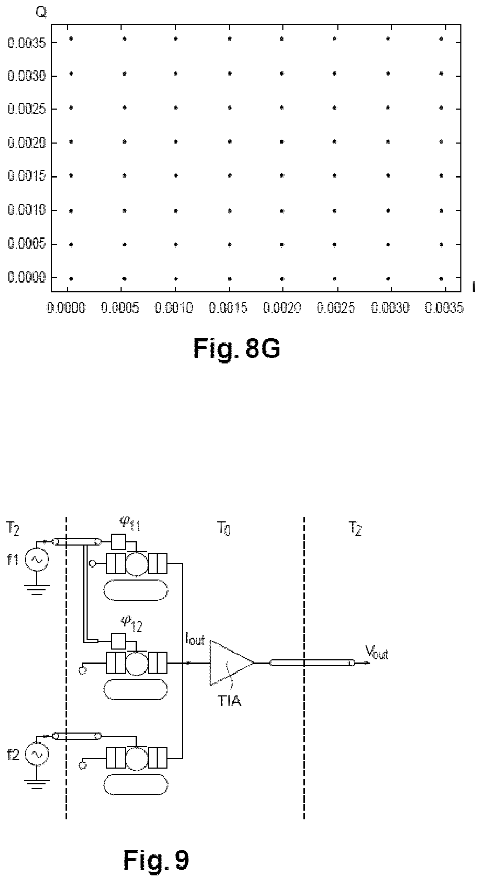

134. Les figures 8D, 8E et 8F, 8G montrent deux autres répartitions de phases possibles et intéressantes. Celles-ci se rapprochent toutes deux d'une constellation QAM, connue pour être optimisée en terme d'espacement des symboles (ou combinaison d'états).

135. [Fig. 8D] En figure 8D une répartition en amplitude et en phase est mise en place sur le cercle trigonométrique complet (360°). Pour attribuer une phase aux différents qubits ordonnés, les phases sont successivement incrémentées de *π*/2 radians en passant d'un qubit au qubit suivant de la liste. Les amplitudes, quant à elles, sont choisies de la manière suivante : à partir de n =1, pour n impair, la même amplitude est attribuée au qubit n et au qubit n+1 et les amplitudes sont attribuées à chaque nombre impair successif en divisant la précédente amplitude par 2. La répartition obtenue pour 6 qubits est présentée en figure 8D.

136. [Fig. 8E] Les combinaisons d'états résultantes sont représentées en figure 8E. Il est possible de placer n'importe quel nombre de qubits par fréquence, que ce nombre soit premier ou non. Le plan IQ est optimalement occupé.

137. [Fig. 8F] Dans une autre variante, les phases sont alternativement 0 et *π*/2 (ou n'importe quel autre paire de phases séparées de *π*/2). Ensuite, les amplitudes sont attribuées comme précédemment : à partir de n =1, pour n impair, la même amplitude est attribuée au qubit n et au qubit n+1 et les amplitudes sont attribuées à chaque nombre impair successif en divisant la précédente amplitude par 2. La répartition obtenue pour 6 qubits est présentée en figure 8F.

138. [Fig. 8G] Les combinaisons d'états résultantes sont représentées en figure 8G. A nouveau il est possible de placer n'importe quel nombre de qubits par fréquence, que ce nombre soit premier ou non. Le premier quadrant du plan IQ est encore optimalement occupé.

139. Ces deux choix de répartitions des phases en quadrature et amplitudes en puissance de 2 correspondent respectivement à interpréter les états des qubits comme des mots en négabinaire (phases à 0, π/2, π et 3π/2, les phases à π et 3π/2 équivalant à des amplitudes en puissances de -2) ou en binaire (phases à 0 et π/2) sur chaque axe I et Q. 140. Ces répartitions de phase et amplitude sont puissantes en termes d'occupation du plan IQ.

141. Dans un circuit dans lequel l'objectif principal est de respecter un temps de lecture de 1 à 2 µs, il est proposé de placer 2 ou 3 phases par fréquences. Dans un circuit où l'augmentation du nombre de qubits est la priorité quitte à allonger le temps de lecture, il est proposé de placer 4 ou 5 phases par fréquences pour un temps de lecture autour de la dizaine de µs.

142. En utilisant plusieurs fréquences, la chaîne de lecture peut atteindre une centaine de qubits avec un seul câble électrique sortant du cryostat enfermant les qubits, avec un temps de lecture de 1 µs et une consommation de l'ordre de 100 µW.

143. [Fig. 9] Aux figures 9 à 12, on a représenté deux générateurs de fréquence, f1 et f2, et deux qubits pour le générateur de fréquence f1, et un qubit pour le générateur de fréquence f2, mais ce nombre de qubits a été choisi par facilité de représentation. L'invention prévoit un nombre souvent plus élevé de fréquences, et plusieurs, et souvent plus de deux, qubits par fréquence. Les figures 9 à 12 discutent non pas de cela, mais de la température à laquelle la chaîne d'amplification et les déphaseurs sont installés. Les deux déphaseurs représentés pour la fréquence f1 sont notés φ11 et φ12 et les déphaseurs pour la fréquence f2 ne sont pas représentés. Ils sont installés à un étage de température plus basse que les générateurs de fréquences f1, f2 ..., et un câble unique, par fréquence, pénètre dans leur étage de température depuis l'extérieur de cet étage de température (il s'agit de pénétrer une enceinte cryostatique), ce câble faisant l'objet d'une parallélisation en plusieurs câbles transportant la même fréquence à l'intérieur de l'enceinte de température des déphaseurs.

144. La chaîne de gain est, dans un mode de réalisation présenté en figure 9, constituée essentiellement d'un TIA dans le cryostat des qubits et des SETs, et donc à très basse température T0 (moins de 1K dans un mode de réalisation), comme cela est représenté en figure 9. La capacité en entrée du TIA (liée à la longueur de ligne en entrée) peut être faible, ce qui est avantageux, mais par contre la capacité en sortie (liée à la longueur de ligne en sortie) est inévitablement assez élevée, ce qui peut être désavantageux, tout comme le fait que le TIA qui doit offrir un gain élevé de l'ordre de 10⁶V/A doit consommer peu, de l'ordre de 100µW, et ne pas produire de bruit empêchant une lecture de fidélité supérieure à 99,99% en quelques µs. Ce positionnement du TIA dans le cryostat impose donc des contraintes sur le TIA, qu'il est proposé de réduire en positionnant dans un mode de réalisation alternatif, le TIA à l'extérieur de l'étage de température le plus froid.

145. Le rapport signal sur bruit en sortie de la chaîne d'amplification d'une bande passante de 40 MHz a une valeur limite de 1,383 afin d'assurer une fidélité de lecteur de 99.99%, les moyens de démodulation ayant un temps de lecture de l'ordre de 1 µs. La valeur de 1,383 est la valeur de rapport signal sur bruit requise en sortie de la chaîne d'amplification d'une bande passante de 40 MHz afin d'atteindre un taux d'erreur binaire (ou Bit Error Rate, ou BER en anglais) de 0,01% pour une démodulation OOK (On Off Keying) avec un temps de lecture de 1µs (et donc une intégration de 1µs). La démodulation OOK correspondant au cas à 1 seule phase par fréquence. La relation est la suivante : BER=1/2 erfc(√(SNR)/(2√2)).

146. Les déphaseurs φ11 et φ12 et les autres déphaseurs sont placés dans le cryostat de température T0.

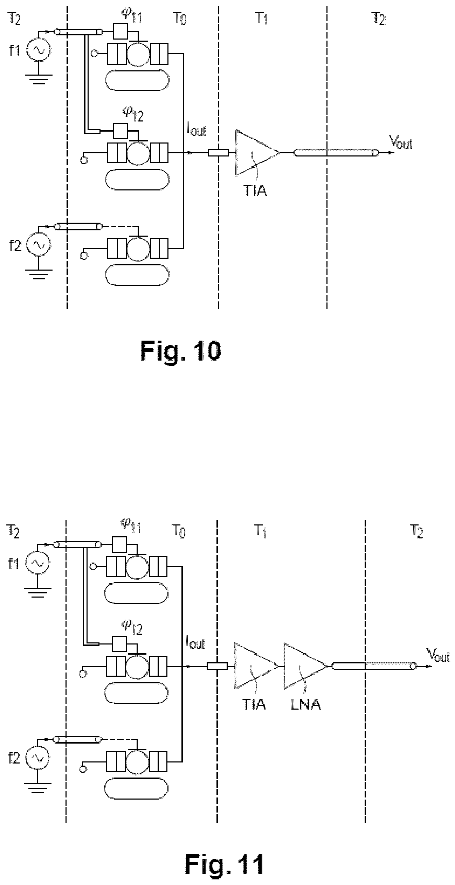

147. [Fig. 10] Alternativement, comme cela est représenté en figure 10, le TIA est placé dans un environnement de température intermédiaire T1 (par exemple 4K), comprise entre la température T0 de l'étage de température des qubits de spin et la température ambiante. On évoque ici un cryostat avec des enceintes successives de tailles décroissantes, l'enceinte la plus froide étant installée dans l'enceinte de température intermédiaire. A un tel étage de température intermédiaire, le budget de consommation est plus permissif qu'à moins de 1K, ainsi, un tel TIA est moins contraint en consommation que le TIA du mode de réalisation précédent qui était placé à moins de 1K. Un tel placement du TIA offre ainsi une plus grande flexibilité d'utilisation que celui du mode de réalisation précédent.

148. A nouveau, Les déphaseurs φ11 et φ12 et les autres déphaseurs sont placés dans le cryostat de température T0, mais ils pourraient être placés dans l'étage de température T1, notamment si les générateurs de fréquence sont à l'étage de température T2.

149. [Fig. 11] Dans un autre mode de réalisation, représenté en figure 11, un TIA d'un premier gain, par exemple 10000 V/A précède sur la ligne de lecture (unique comme précédemment) un amplificateur, par exemple un amplificateur à bas bruit LNA (tension/tension) d'un deuxième gain, par exemple 100. L'effet conjugué des deux amplificateurs permet d'obtenir un gain global de 1000000 V/A. Les deux amplificateurs sont mis en place matériellement en série à une température intermédiaire T1, comprise entre la température de l'étage de température des qubits de spin et la température ambiante. On évoque encore ici un cryostat avec des enceintes successives de tailles décroissantes, l'enceinte la plus froide étant installée dans l'enceinte de température intermédiaire. Un tel choix permet alors de diminuer les contraintes de conception et de fonctionnement pesant sur le TIA, qui avec un gain plus faible peut avoir une plus grande bande passante, de l'ordre de 100MHz sans consommer plus. Le LNA peut avoir une bande passante d'une centaine de MHz et consommer de l'ordre de 1 mW. Le TIA, qui est préférentiellement directement relié au deuxième amplificateur pour tirer parti du fait qu'ils sont dans la même enceinte cryostatique, et n'ayant en conséquence pas de ligne de transmission à sa sortie, a une capacité en sortie plus faible ce qui permet d'avoir des performances élevées.

150. A nouveau, Les déphaseurs φ11 et φ12 et les autres déphaseurs sont placés dans le cryostat de température T0, mais ils pourraient être placés dans l'étage de température T1, notamment si les générateurs de fréquence sont à l'étage de température T2.

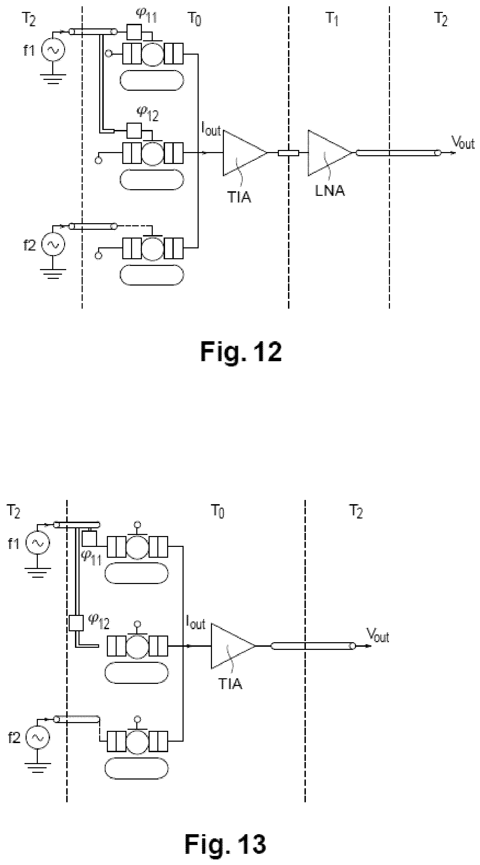

151. [Fig. 12] Dans un autre mode de réalisation, représenté en figure 12, un TIA précède à nouveau sur la ligne de lecture un deuxième amplificateur, par exemple un LNA. Les deux amplificateurs sont par contre mis en place matériellement dans des environnements à des températures différentes : le TIA est à proximité des qubits et des SET dans l'étage de température à très basse température, par exemple à moins de 1K, et donc a une capacité en entrée faible, ce qui est avantageux. D'un autre côté, avoir un amplificateur à étage intermédiaire permet de limiter la capacité en sortie du TIA, ce qui est aussi avantageux. Le deuxième amplificateur peut être placé à une température intermédiaire.

152. A nouveau, Les déphaseurs φ11 et φ12 et les autres déphaseurs sont placés dans le cryostat de température T0, mais ils pourraient être placés dans l'étage de température T1, notamment si les générateurs de fréquence sont à l'étage de température T2. On évoque encore ici un cryostat avec des enceintes successives de tailles décroissantes, l'enceinte la plus froide étant installée dans l'enceinte de température intermédiaire.

153. La chaîne d'amplification peut être construite à l'aide de plusieurs circuits discrets, et/ou à l'aide d'un ou plusieurs circuits intégrés.

154. Le TIA peut être de différentes architectures, parmi lesquels l'architecture « retour capacitif » ou « réseau capacitif » (capacitive feedback ou capacitive network), l'architecture push-pull (poussé-tiré ou montage symétrique en français, mais la terminologie anglaise est préférée), shunt-feedback (retour de shunt en français, mais à nouveau la terminologie anglaise est préférée), ou cascode régulé. Ces architectures sont présentées dans les publications Razavi, 2000 et Romanova, 2019. On privilégie un TIA qui ait une bande passante aussi large que possible, un gain aussi important que possible, une consommation faible et une faible génération de bruit.

155. Dans les modes de réalisation des figures 9 à 12, les générateurs de fréquence sont préférentiellement à la même température que le circuit de démodulation. Cette température est notée T2, et il peut s'agir de la température ambiante (environ 300 K), mais il peut aussi s'agir de T1.

156. Ainsi, dans un autre mode de réalisation, les générateurs de tension sont placés à un niveau de température intermédiaire, qui est entre la température ambiante et la température des qubits, ce choix de température pouvant permettre d'optimiser la consommation énergétique du système et le placement de câbles au travers du cryostat. Dans un autre mode de réalisation, les générateurs de tension sont placés à la température des qubits, dans le cryostat, ce qui permet de minimiser le nombre de câbles passant au travers et entrant dans le cryostat.

157. Les générateurs de tension sont construits à l'aide de circuits discrets ou intégrés. Une topologie dite de « ring oscillator » aussi appelé en français générateur de créneaux est particulièrement appropriée. Dans d'autres modes de réalisation, les générateurs de tension sont construits sous la forme d'oscillateurs à injection ou d'oscillateurs à relaxation. L'excitation par ces générateurs de tension est appliquée sur la grille du transistor SET concernée. Elle est d'une fréquence adaptée à chaque groupe de qubits auquel une fréquence donnée est assignée, et pour chaque qubit, elle est décalée d'une phase et atténuée d'une amplitude conformément aux principes de l'invention.

158. Les signaux de tous les SETs se retrouvent avant démodulation sur un câble commun (une ligne de transmission radiofréquence transmettant un signal multiplexé en fréquence). Les circuits de démodulation peuvent donc être placés à température ambiante, le nombre de câbles traversant le cryostat étant limité, puisque le câble est unique. Ils peuvent aussi être placés à basse température, si cela est par ailleurs avantageux pour la mise en oeuvre.

159. La chaîne de démodulation est dans certains modes de réalisation implémentée dans un étage intermédiaire de température, par exemple compris entre 4K et 10K. Dans ces différentes situations, le fait que l'étage de température des qubits, qui maintient une température à moins de 1 K, ne soit traversé que par un unique câble sortant et ne contiennent pas l'électronique de démodulation est avantageux.

160. La démodulation peut être homodyne (comme présenté ci-dessus) ou hétérodyne, avec alors l'utilisation d'une fréquence intermédiaire. La solution hétérodyne permet dans certaines mises en oeuvre de diminuer le bruit de la chaîne de démodulation, et d'augmenter sa bande passante.

161. Une chaîne de démodulation analogique est utilisée dans un mode de réalisation. Dans un autre mode de réalisation, la démodulation est effectuée à l'aide d'un processeur de circuit numérique DSP, et dans un autre mode de réalisation, c'est un ASIC qui est programmé pour réaliser la démodulation.

162. La discrimination est effectuée par technique région d'intérêt ROI utilisant dans un mode de réalisation comme forme de discrimination dans le plan des cercles ou des ellipses, ou des rectangles voire des carrés. Elle peut aussi être menée par identification du plus proche voisin.

163. Ainsi on utilise un nombre de phases par fréquence important, malgré le bruit résiduel (après tous les efforts de conception pour le réduire) de la chaine d'amplification et de démodulation.

164. Le multiplexage en phase tel que présenté ci-dessus s'applique à une lecture par charge de qubits de spin sur silicium, au travers de SETs dont la conductance varie en fonction de l'état du qubit, et également à la lecture d'autre dispositifs quantiques, comme les qubits de spin sur silicium à l'aide d'un QPC dont la conductance varie en fonction de l'état du qubit.

165. [Fig. 13] Les SETs peuvent être connectés pour une excitation non pas par leur grille mais par leur drain, comme montré en figure 13. Alors la grille est connectée à un potentiel fixe ou non fixe. Et le drain reçoit la tension périodique, avec la fréquence attribuée à un groupe de plusieurs qubits, et parmi ceux-ci la phase attribuée spécifiquement au qubit concerné.

166. Il est précisé de plus que les SETs, en figure 1A (et suivantes) ou en figure 13, peuvent comporter d'autres grilles. Celles-ci sont reliées à un potentiel fixe ou non fixe.

167. Il est aussi précisé que les SETs peuvent être remplacés par des électromètres fournissant une réponse en tension, et les tensions de sortie des électromètres sont additionnées. Pour faire une telle addition, tout en conservant le placement en parallèle des électromètres, on ajoute une capacité de valeur donnée C (identique pour chaque électromètre) en série à la sortie de chaque électromètre. Les deuxièmes bornes des différentes capacités sont reliées entre elles en un noeud, et une capacité de valeur identique est placée en parallèle, une de ses bornes à la masse et son autre borne au nœud mentionné ci-dessus. Ainsi si les électromètres ont une sortie en potentiel, les capacités ainsi placées forment un pont diviseur capacitif et on a alors au nœud un potentiel proportionnel à la somme des potentiels de sortie des électromètres.

168. Puis les tensions additionnées font l'objet d'une amplification, par exemple par un LNA, puis d'une démodulation pour retrouver les signaux des différents qubits, dont l'excitation est faite à la même fréquence, mais avec des phases décalées.

169. L'invention permet de lire plus de qubits tout en gardant un bloc d'amplification (un TIA et/ou un amplificateur tension/tension) de performance inchangée. Le nombre de câbles entrant dans une des enceintes de température, potentiellement l'enceinte de température la plus froide, est inchangé, ce qui est remarquable.

### Liste des documents cités

Park, 2021 : Park et al., A fully integrated cryo-CMOS SoC for state manipulation, readout and high-speed gate pulsing of spin qubits, IEEE Journal of solid state circuits, vol. 56, n° 11, 3289-3306
Jerger, 2012: Jerger et al., Frequency division multiplexing readout and simultaneous manipulation of an array of flux qubits arXiv:1205.6375v2
Morel, 2022: EP4016402A1
Abdo, 2018: WO2018/185542
Naaman, 2021: WO2021/061776
Bronn, 2022: US2022/0140927
Gong, 2019: Gong et al. Design Considerations for Spin Readout Amplifiers in Monolithically Integrated Semiconductor Quantum Processors, 2019 IEEE Radio Frequency Integrated Circuits Symposium, Boston, Massachusetts, 2 - 4 June 2019, IEEE Catalog Number: CFP19MMW-POD
Razavi, 2000: "A 622 Mb/s 4.5 pA//spl radic/Hz CMOS transimpedance amplifier," 2000 IEEE International Solid-State Circuits Conference. Digest of Technical Papers (Cat. No.00CH37056), San Francisco, CA, USA, 2000, pp. 162-163, doi: 10.1109/ISSCC.2000.839732.
Romanova, 2019: Romanova et Barzdenas "A Review of Modern CMOS Transimpedance Amplifiers for OTDR Applications. Electronics 2019, 8, 1073. https://doi.org/10.3390/electronics8101073
Williams, 2009 : EP2075745A1

## Revendications

1. Dispositif quantique comprenant un cryostat, une pluralité de qubits (11, 12,...,1M, 21...) dans une enceinte de température du cryostat, et pour chaque qubit de la pluralité de qubits, un électromètre (S11, S12, ... S1M, S21 ...) couplé audit qubit pour extraire un signal de lecture d'un état courant du qubit, les signaux de lecture des qubits de la pluralité étant additionnés sur une ligne de lecture commune (50) du dispositif quantique, puis transmis à un circuit de démultiplexage (200) du dispositif quantique, les excitations périodiques transmises à un groupe de plusieurs électromètres (S11, S12, ... S1M ) du dispositif l'étant avec une fréquence identique (f1) à l'aide d'un moyen de génération synchronisé (V1, V2 ...) du dispositif quantique extérieur à ladite enceinte de température, le dispositif quantique étant de plus **caractérisé en ce qu'**il comprend des moyens de déphasage et d'atténuation d'amplitude (Phi1, Phi2, ... PhiM) dans ladite enceinte de température introduisant des déphasages distincts dans les excitations appliquées respectivement aux électromètres (S11, S12, ... S1M ) dudit groupe.

2. Dispositif quantique selon la revendication 1, dans lequel les moyens de déphasage (Phi1, Phi2, ... PhiM) sont aussi des moyens d'atténuation d'amplitude.

3. Dispositif quantique selon la revendication 1 ou la revendication 2, dans lequel les moyens de déphasage (Phi1, Phi2, ... PhiM) sont des longueurs de câbles différentes, des déphaseurs réglables, des oscillateurs à injection ou des chaines d'inverseurs CMOS.

4. Dispositif quantique selon l'une des revendications 1 à 3, dans lequel les électromètres (S11, S12, ... S1M, S21 ...) sont répartis en plusieurs groupes, chaque groupe recevant une excitation avec une fréquence distincte (f1, f2) de celles des autres groupes, et la ligne de lecture commune (50) étant commune aux électromètres des différents groupes.

5. Dispositif quantique selon l'une des revendications 1 à 4, dans lequel chaque électromètre (S11, S12, ... S1M, S21 ...) comprend un transistor à un électron, le signal de lecture étant un courant.

6. Dispositif quantique selon l'une des revendications 1 à 5, dans lequel les qubits sont des qubits de spin, et chaque couple qubit et électromètre associé est couplé capacitivement par des boites quantiques de l'un et de l'autre.

7. Dispositif quantique selon l'une des revendications 1 à 6, dans lequel les phases associées aux électromètres dudit groupe sont essentiellement réparties régulièrement tous les 2π/n radians, n étant un entier naturel premier supérieur ou égal à 3, et la répartition des signaux associés aux symboles dans le plan IQ est rendue secondairement irrégulière.

8. Dispositif quantique selon la revendication 7, dans lequel le nombre des électromètres du groupe est n-1, une quelconque des n valeurs 2π/n radians n'étant attribuée à aucun électromètre du groupe.

9. Dispositif quantique selon la revendication 7, dans lequel le nombre des électromètres du groupe est n, et les phases associées aux électromètres sont réparties dans l'intervalle 0 à 2π radians selon une répartition de premier ordre régulière mais comprenant, dans un ordre de grandeur inférieur un décalage de phase supprimant la superposition entre le symbole ne comprenant que des 0 et le symbole ne comprenant que des 1.

10. Dispositif quantique selon la revendication 7, dans lequel le nombre des électromètres du groupe est n, l'amplitude d'une des excitations au moins étant diminuée ou augmentée par rapport à au moins une autre afin de limiter les symétries de la répartition de phase choisie.

11. Dispositif quantique selon l'une des revendications 1 à 6, dans lequel les phases associées aux électromètres dudit groupe sont essentiellement réparties régulièrement tous les π/n radians, n étant un entier naturel supérieur ou égal à 4, et n étant le nombre maximal d'électromètres, et leur répartition est rendue secondairement irrégulière si n est supérieur ou égal à 5.

12. Dispositif quantique selon l'une des revendications 1 à 6, dans lequel les amplitudes sont attribuées selon la règle à partir de n =1, pour n impair, la même amplitude est attribuée au qubit n et au qubit n+1 et les amplitudes sont attribuées à chaque nombre impair successif en divisant la précédente amplitude par 2, les phases associées aux électromètres dudit groupe étant successivement incrémentées de *π*/2 radians en passant d'un qubit au qubit suivant, prenant alternativement deux valeurs décalées de *π*/2.

13. Dispositif quantique selon l'une des revendications 1 à 12, dans lequel ladite enceinte de température est l'enceinte de température (T0) des qubits.

14. Dispositif quantique selon l'une des revendications 1 à 12, dans lequel ladite enceinte de température est une enceinte de température intermédiaire (T1), les qubits étant dans une enceinte de température plus basse (T0) que ladite enceinte de température intermédiaire (T1) et interne à celle-ci, et les moyens de déphasage (Phi1, Phi2, ... PhiM) étant à l'extérieur de l'enceinte de température plus basse (T0) mais à l'intérieur de l'enceinte de température intermédiaire (T1), qui renferme également un amplificateur (100) pour amplifier le signal sur la ligne de lecture commune (50).

## Patentansprüche

1. Quantenvorrichtung, umfassend einen Kryostaten, eine Vielzahl von Qubits (11, 12,...,1M, 21...) in einer Temperaturkammer des Kryostaten und für jedes Qubit der Vielzahl von Qubits ein Elektrometer (S11, S12, ... S1M, S21 ...), das mit dem Qubit gekoppelt ist, um ein Lesesignal eines aktuellen Zustands des Qubits zu extrahieren, wobei die Lesesignale der Qubits der Vielzahl auf einer gemeinsamen Leseleitung (50) der Quantenvorrichtung addiert, danach an eine Demultiplexerschaltung (200) der Quantenvorrichtung übertragen werden, wobei die an eine Gruppe von mehreren Elektrometern (S11, S12, ... S1M ) der Vorrichtung übertragenen periodischen Anregungen dies mit Hilfe eines synchronisierten Erzeugungsmittels (V1, V2 ... ) der Quantenvorrichtung außerhalb der Temperaturkammer mit einer identischen Frequenz (f1) werden, wobei die Quantenvorrichtung weiter **dadurch gekennzeichnet ist, dass** sie Mittel zur Phasenverschiebung und Amplitudendämpfung (Phi1, Phi2, ... PhiM) in der Temperaturkammer umfasst, die unterschiedliche Phasenverschiebungen in den jeweiligen an die Elektrometer (S11, S12, ... S1M ) der Gruppe angelegten Anregungen einführen.

2. Quantenvorrichtung nach Anspruch 1, wobei die Mittel zur Phasenverschiebung (Phi1, Phi2, ... PhiM) auch Mittel zur Amplitudendämpfung sind.

3. Quantenvorrichtung nach Anspruch 1 oder Anspruch 2, wobei die Mittel zur Phasenverschiebung (Phi1, Phi2, ... PhiM) verschiedene Kabellängen, regelbare Phasenverschieber, Injektionsoszillatoren oder Wechselrichterketten CMOS sind.

4. Quantenvorrichtung nach einem der Ansprüche 1 bis 3, wobei die Elektrometer (S11, S12, ... S1M, S21 ...) in mehreren Gruppen verteilt sind, wobei jede Gruppe eine Anregung mit einer von jenen der anderen Gruppen unterschiedlichen Frequenz (f1, f2) empfängt und die gemeinsame Leseleitung (50) den Elektrometern der verschiedenen Gruppen gemeinsam ist.

5. Quantenvorrichtung nach einem der Ansprüche 1 bis 4, wobei jedes Elektrometer (S11, S12, ... S1M, S21 ...) einen Einzelelektronentransistor umfasst, wobei das Lesesignal ein Strom ist.

6. Quantenvorrichtung nach einem der Ansprüche 1 bis 5, wobei die Qubits Spinqubits sind und jedes Paar von Qubit und assoziiertem Elektrometer durch Quantenpunkte des einen und des anderen kapazitiv gekoppelt sind.

7. Quantenvorrichtung nach einem der Ansprüche 1 bis 6, wobei die mit den Elektrometern der Gruppe assoziierten Phasen im Wesentlichen regelmäßig um die 2π/n Radianten verteilt sind, wobei n eine erste natürliche ganze Zahl größer als oder gleich 3 ist und die Verteilung der mit den Symbolen in der IQ-Ebene assoziierten Signale sekundär unregelmäßig gemacht wird.

8. Quantenvorrichtung nach Anspruch 7, wobei die Anzahl von Elektrometern der Gruppe n-1 beträgt, wobei ein beliebiger der n Werte der 2π/n Radianten keinem der Elektrometer der Gruppe zugeordnet ist.

9. Quantenvorrichtung nach Anspruch 7, wobei die Anzahl von Elektrometern der Gruppe n beträgt und die mit den Elektrometern assoziierten Phasen in dem Intervall 0 bis 2π Radianten gemäß einer Verteilung erster Ordnung regelmäßig verteilt sind, aber in einer kleineren Größenordnung einen Phasenversatz umfassen, der die Überlagerung zwischen dem Symbol, das nur Nullen umfasst, und dem Symbol, das nur Einsen umfasst, unterdrückt.

10. Quantenvorrichtung nach Anspruch 7, wobei die Anzahl von Elektrometern der Gruppe n beträgt, wobei die Amplitude einer der Anregungen in Bezug auf mindestens eine andere mindestens verringert oder erhöht ist, um die Symmetrien der gewählten Phasenverteilung zu begrenzen.

11. Quantenvorrichtung nach einem der Ansprüche 1 bis 6, wobei mit den Elektrometern der Gruppe assoziierten Phasen im Wesentlichen regelmäßig um die 2π/n Radianten verteilt sind, wobei n eine natürliche ganze Zahl größer als oder gleich 4 ist und n die maximale Anzahl von Elektrometern ist und ihre Verteilung sekundär unregelmäßig gemacht wird, wenn n größer als oder gleich 5 ist.

12. Quantenvorrichtung nach einem der Ansprüche 1 bis 6, wobei die Amplituden, für n ist ungerade, gemäß der Regel ausgehend von n = 1 verteilt werden, wobei dem Qubit n und dem Qubit n+1 die gleiche Amplitude zugeordnet wird und die Amplituden jeder nachfolgenden ungeraden Zahl zugeordnet werden, indem die vorherige Amplitude durch 2 geteilt wird, wobei die mit den Elektrometern der Gruppe assoziierten Phasen nacheinander beim Übergang von einem Qubit zum folgenden Qubit um π/2 Radianten inkrementiert werden, wobei alternativ zwei Werte genommen werden, die um π/2 versetzt sind.

13. Quantenvorrichtung nach einem der Ansprüche 1 bis 12, wobei die Temperaturkammer die Kammer der Temperatur (T0) der Qubits ist.

14. Quantenvorrichtung nach einem der Ansprüche 1 bis 12, wobei die Temperaturkammer eine Kammer der Zwischentemperatur (T1) ist, wobei die Qubits in einer Kammer niedrigerer Temperatur (T0) als die Kammer der Zwischentemperatur (T1) und innerhalb dieser vorliegen, und die Mittel zur Phasenverschiebung (Phi1, Phi2, ... PhiM) außerhalb der Kammer niedrigerer Temperatur (T0) aber innerhalb der Kammer der Zwischentemperatur (T1) vorliegen, die ebenfalls einen Verstärker (100) zum Verstärken des Signals auf der gemeinsamen Leseleitung umschließt.

## Claims

1. Quantum device comprising a cryostat, a plurality of qubits (11, 12, ... , 1M, 21...) in a temperature enclosure of the cryostat, and for each qubit of the plurality of qubits, an electrometer (511, S12, ... S1M, 521...) coupled to said qubit to extract a signal for reading a current state of the qubit, the signals for reading qubits of the plurality being added on a common reading line (50) of the quantum device, then transmitted to a demultiplexing circuit (200) of the quantum device, the periodic excitations transmitted to a group of several electrometers (S11, S12, ... S1M) of the device being it with an identical frequency (f1) using a synchronized generation means (V1, V2, ...) of the quantum device external to said temperature enclosure, the quantum device being, in addition, **characterized in that** it comprises phase shift and amplitude attenuation means (Phil, Phi2, ... PhiM) in said temperature enclosure introducing distinct phase shifts in the excitations applied respectively to the electrometers (S11, S12, ... S1M) of said group.

2. Quantum device according to claim 1, wherein the phase shift means (Phi1, Phi2, ... PhiM) are also amplitude attenuation means.

3. Quantum device according to claim 1 or claim 2, wherein the phase shift means (Phi1, Phi2, ... PhiM) are different cable lengths, adjustable phase shifters, injection oscillators or CMOS inverter chains.

4. Quantum device according to any one of claims 1 to 3, wherein the electrometers (S11, S12, ... S1M, 521...) are distributed into several groups, each group receiving an excitation with a frequency (f1, f2) distinct from those of the other groups, and the common reading line (50) being common to the electrometers of the different groups.

5. Quantum device according to any one of claims 1 to 4, wherein each electrometer (S11, S12, ... S1M, 521...) comprises a transistor with an electron, the reading signal being a current.

6. Quantum device according to any one of claims 1 to 5, wherein the qubits are spin qubits, and each qubit pair and associated electrometer is capacitively coupled by quantum dots to one another.

7. Quantum device according to any one of claims 1 to 6, wherein the phases associated with the electrometers of said group are mainly distributed regularly every 2π/n radians, n being a natural first integer greater than or equal to 3, and the distribution of the signals associated with the symbols in the plane IQ is made secondarily irregular.

8. Quantum device according to claim 7, wherein the number of electrometers of the group is n-1, any of the n values 2π/n radians not being attributed to any electrometer of the group.

9. Quantum device according to claim 7, wherein the number of electrometers of the group is n, and the phases associated with the electrometers are distributed in the interval 0 at 2π radians according to a regular first-order distribution, but comprising, in an order of magnitude less than a phase offset removing the superimposition between the symbol only comprising 0s and the symbol only comprising 1s.

10. Quantum device according to claim 7, wherein the number of electrometers of the group is n, the amplitude of one of the excitations at least being decreased or increased with respect to at least one other, in order to limit the symmetries of the chosen phase distribution.

11. Quantum device according to any one of claims 1 to 6, wherein the phases associated with the electrometers of said group are mainly distributed regularly every π/n radians, n being a natural integer greater than or equal to 4, and n being the maximum number of electrometers, and their distribution is made secondarily irregular, if n is greater than or equal to 5.

12. Quantum device according to any one of claims 1 to 6, wherein the amplitudes are attributed according to the rule from n = 1, for n odd, the same amplitude is attributed to the qubit n and to the qubit n+1, and the amplitudes are attributed to each successive odd number by dividing the preceding amplitude by 2, the phases associated with the electrometers of said group being successively incremented of π/2 radians, by passing from one qubit to the next qubit, taking alternatively two offset values of π/2.

13. Quantum device according to any one of claims 1 to 12, wherein said temperature enclosure is the temperature enclosure (T0) of the qubits.

14. Quantum device according to any one of claims 1 to 12, wherein said temperature enclosure is an intermediate temperature enclosure (T1), the qubits being in a lower temperature enclosure (T0) than said intermediate temperature enclosure (T1) and internal to it, and the phase shift means (Phil, Phi2, ... PhiM) being outside of the lower temperature enclosure (T0) but inside the intermediate temperature enclosure (T1), which also contains an amplifier (100) to amplify the signal on the common reading line (50).
